# EUROPEAN PATENT SPECIFICATION

(11) **EP 2 009 454 B1**
(45) Date of publication and mention of the grant of the patent: **27.01.2010**
(21) Application number: 07024450.4
(22) Date of filing: 17.12.2007
(51) Int. Cl.: G01R 31/302, G06F 3/041

(54) **Method and system for carrying out non-contact testing of touch panel**
Verfahren und System zum kontaktlosen Prüfen von Berührungsbildschirmen
Procédé et système pour la réalisation d'un essai sans contact d'un panneau tactile

(30) Priority: 29.06.2007 CN 200710126889
(43) Date of publication of application: 31.12.2008
(73) Proprietor: TPK Touch Solutions Inc., Taipei City 106 (TW)
(72) Inventor: Chien, Shun-Ta, Dayuan Township Taoyuan County (TW)
(74) Representative: Muttock, Neil John

(56) References cited:
- EP-A- 0 372 812
- US-A1- 2003 189 555

## Description

### FIELD OF THE INVENTION

The present invention relates generally to the field of testing of a touch panel, and in particular to a method and a system for carrying out non-contact testing of the touch panel with pressurization caused on the touch panel by air jet generated by an air nozzle.

### BACKGROUND OF THE INVENTION

With the development of technology, control and input of a lot of electronic, information, and communication devices have been recently upgraded from traditional push button/keyboard/keypad based input means to touch control means. In other words, the input or control of these devices is no longer limited to for example a keyboard or a computer mouse and, instead, moving a finger along a touch panel and selectively touching/depressing the touch panel are used to control these devices and enter data/instructions to these devices.

The touch panels are now widely employed in for example a display of a portable computer, input means of a portable personal communication device, various household electrical appliances, public information systems, and office automation devices.

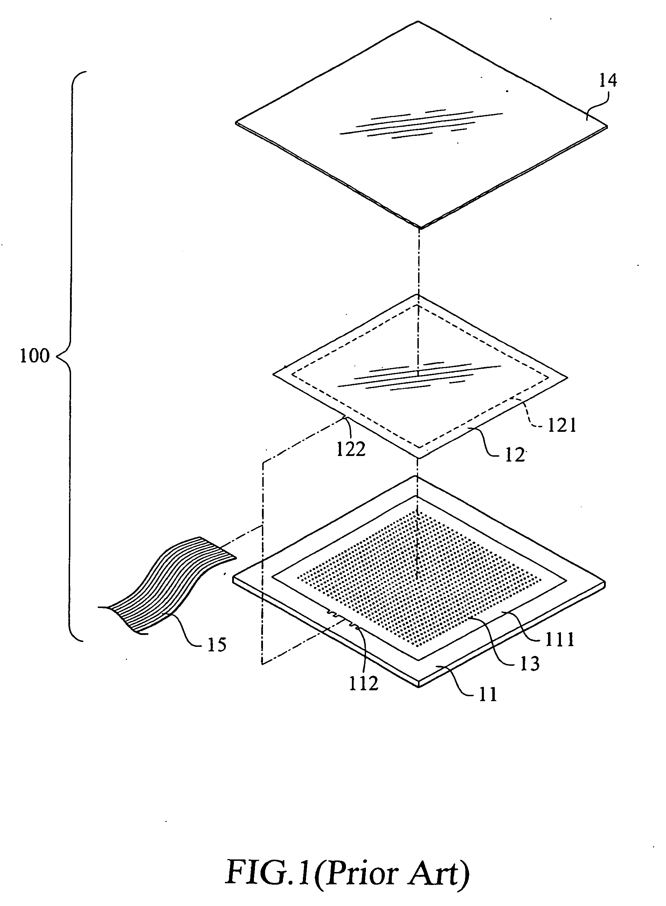

Figure 1 of the attached drawings shows an exploded view of a conventional touch panel. The conventional touch panel, which is generally designated at 100 in Figure 1, comprises a glass substrate 11 having a surface on which a transparent conductive layer 111, such as an ITO layer, is coated so that the glass substrate 11 and the transparent conductive layer 111 form an electrically conductive glass panel. The electrically conductive glass panel is covered with a film 12, which has a bottom surface coated with a transparent conductive layer 121 opposing the transparent conductive layer 111 of the glass substrate 11. A plurality of insulation spacer 13 is arranged between the transparent conductive layer 111 of the glass substrate 11 and the transparent conductive layer 121 of the film 12 to separate the transparent conductive layer 111 from the transparent conductive layer 121. Often, a protection layer 14 is provided to cover a top face of the film 12.

The transparent conductive layer 111 of the glass substrate 11 and the transparent conductive layer 121 of the film 12 are respectively provided with signal contacts 112, 122 to which a signal transmission line 15 is connected to send out signals generated due to depression or actuation of the touch panel 100.

In the manufacturing of the touch panel 100, a conventional manufacturing process comprises etch-resistant printing applied to a glass substrate, etching and film peeling, printing of insulation spacer, printing of sliver lines, printing of insulation layer, and printing of frame to complete the manufacturing of an electrically conductive glass panel. The manufacturing of the conductive film is substantially similar. The electrically conductive glass panel and the conductive film so manufactured are then stacked together, and thereafter subjected to trimming and connection with a flat line to complete the manufacturing of the touch panel.

After the touch panel has been so manufactured, a linearity testing is taken to inspect if the touch panel meets the required electrical performance and satisfies the desired quality. The linearity testing is a major testing for electrical characteristics.

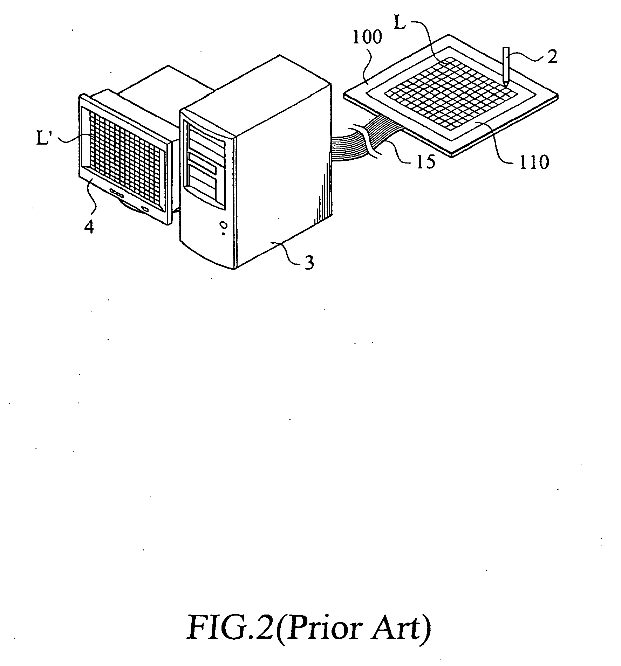

In the conventional method for carrying linearity testing, as shown in Figure 2, a practical touch/depression is carried out for the testing, wherein a pressurizing testing stylus 2 is positioned on the touch panel 100 to actually touch and depress the surface of the touch panel 100. As to the connection of signal, the signal transmission line 15 is connected to an testing system 3 in which programs for reading signals and analysis are pre-loaded so that the testing system 3 reads signals from the touch panel 100 through the signal transmission line 15 and further analyze the signals so read for displaying on a display 4 of the testing system 3. To carry out the testing, the stylus 2 touches and depresses the touch panel 100 along a predetermined testing route L defined in directions of X-axis and Y-axis to apply pressure to, draw lines on, and make displacement on the touch panel 100, whereby due to the pressurization of the touch panel 100, the transparent conductive layer 111 of the glass substrate 11 and the transparent conductive layer 121 of the film 12 of the touch panel 100 are forced to get into contact with each other, inducing a signal of touch. The signal of touch is then transmitted through the signal transmission line 15 to the testing system 3 and is subsequently read and analyzed by the testing system 3, and an testing route L' corresponding to the signals read is displayed on the display 4 of the testing system 3. Based on the result displayed, a determination can be made if the touch panel is qualified for the linearity testing.

In such a conventional manner of testing, where a pressurizing testing stylus is used to carry out the testing of a touch panel, direct contact and pressurization are applied to the surface of the touch panel to carry out the testing so that the stylus itself becomes a major factor of testing for the touch panel. For example, when the stylus is put in contact with the surface of the touch panel, contact pressurization applied to the touch panel by the stylus and displacement of the stylus on the touch panel have to be controlled by a specific jig or controller. In case of poor design of the jig or controller or in case that a contact point of the stylus is of poor configuration or the surface of the touch panel is uneven, damage or scrape may be easily caused on the surface of the touch panel. When the touch panel with such a damage or scrape is put into market, the damage or scrape, no matter how minute it may be, will be considered as a major flaw by the general consumers. In addition, in case that tiny contamination particles attached on the surface of the touch panel at the time the testing is carried out, the stylus, when displacing on the surface of the touch panel, may be stuck by the particles, and may apply a pressure to the surface of the touch panel through the particles that exist between the stylus and the surface of the touch panel, again causing undesired damage on the surface of the touch panel.

A touch panel inspection device is disclosed in US 2003/0189555.

Thus, the present invention is aimed to overcome such a drawback occurring in the conventional testing of a touch panel that is carried by a pressurization testing stylus in order to ensure the quality of the products of touch panels.

### SUMMARY OF THE INVENTION

An objective of the present invention is to provide a non-contact linearity testing method for a touch panel, which allows testing of the touch panel to be carried out without contact with the surface of the touch panel.

Another objective of the present invention is to provide a method that uses an air jet to carry out a linearity testing for a touch panel, wherein the air jet that is generated by an air nozzle applies a pressure to the surface of the touch panel and thus induces a touch signal in the touch panel, to replace the conventional way of generating the touch signal by a pressurization testing stylus directly contacting the touch panel.

A further objective of the present invention is to provide method that may carry out linearity testing of a touch panel and, at the same time, cleaning out minute contamination particles that are possibly stuck to the surface of the touch panel.

Yet a further objective of the present invention is to provide a non-contact testing system for testing a touch panel, which comprises an air nozzle, an air supply source, and a testing system, wherein the air supply source supplies air/gas to the air nozzle and the air nozzle generates an air jet or gas flow toward a surface of a touch panel to be inspected so that the touch panel generates a touch signal corresponding to the air jet. The touch signal may then be applied through a signal transmission line to the testing system for subsequent processing.

In accordance with the present invention, a technical solution for the above discussed problem resides in that an air nozzle is arranged close to a surface of a touch panel to be inspected with a predetermined gap or distance between an air jet orifice of the air nozzle and the surface of the touch panel. The air nozzle, when coupled to an air supply source, is provided with air that forms an air jet at the air jet orifice of the air nozzle and moves toward the touch panel. Under the control of a testing system, the air nozzle, located above the surface of the touch panel, takes movement along a predetermined route. The touch panel, which is acted upon by the air jet, causes a touch signal corresponding to the moving route of the air nozzle. The testing system receives the touch signal and determines if the inspected touch panel passes the linearity testing or not.

The present invention carries out the testing of a touch panel by applying an air jet to a surface of the touch panel under testing to induce a touch signal that is conventionally induced by direct contact of a pressurizing testing stylus with the surface of the touch panel, whereby testing of electrical characteristics of the touch panel can be carried out without direct physical contact of the touch panel surface. Thus, the method in accordance with the present invention does not cause potential risks of damage, scrape or breakage of the touch panel, and consequently, testing of the touch panel can be enhanced. Good yield of the touch panel product can also be improved. Further, in carrying out testing of the touch panel in accordance with the present invention, the air jet, which serves to apply a pressure to the surface of the touch panel to induce the touch signal, also functions to remove or clean out minute contamination particles attaching to the surface of the touch panel. As a result, the overall process of manufacturing and testing of touch panel products can be simplified, eliminating the problem occurring in the conventional manufacturing process of touch panel wherein testing and cleaning of the touch panel must be carried out separately.

### BRIEF DESCRIPTION OF THE DRAWINGS

The present invention will be apparent to those skilled in the art by reading the following description of a preferred embodiment thereof, as well as the best mode to carry out the present invention, with reference to the attached drawings, in which:
Figure 1 is an exploded view of a conventional touch panel;
Figure 2 is a perspective view illustrating an arrangement for carrying out conventional contact testing of a touch panel;
Figure 3 is a perspective view illustrating an arrangement for carrying out non-contact testing of a touch panel in accordance with the present invention;
Figure 4 is a flow chart of a non-contact testing method in accordance with the present invention for testing a touch panel;
Figure 5 is a cross-sectional view illustrating that an air nozzle is arranged above a surface of a touch panel with no air jet applied to the surface of the touch panel; and
Figure 6 is a cross-sectional view illustrating that the air nozzle arranged above the surface of the touch panel generates an air jet in an air jet orifice thereof toward the surface of the touch panel.

### DETAILED DESCRIPTION OF THE PREFERRED EMBODIMENTS

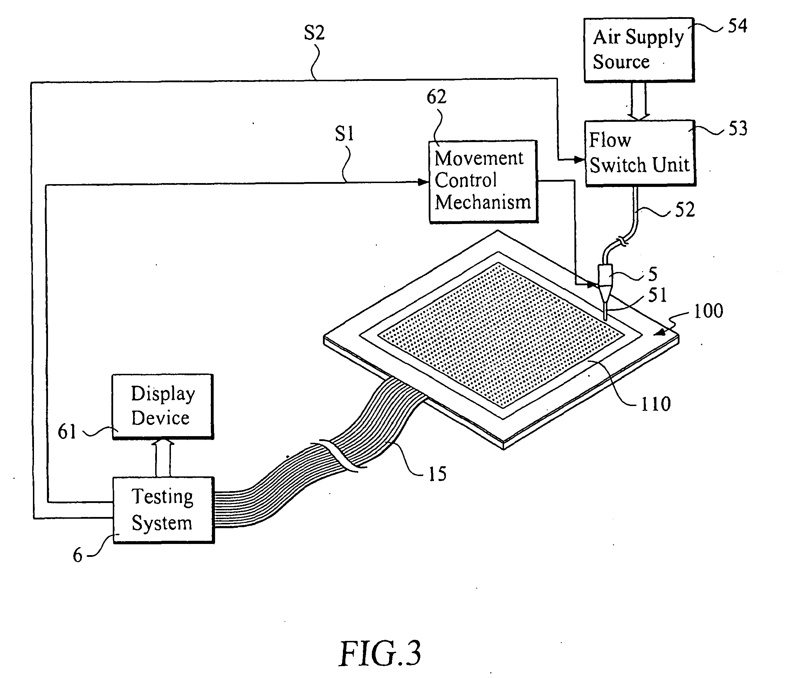

With reference to the drawings and in particular to Figure 3, an arrangement for carrying out non-contact testing of a touch panel in accordance with the present invention is illustrated. As shown, in accordance with the present invention, a touch panel, generally designated at 100, which has been previously manufactured and is subjected to testing, is provided. An air nozzle 5 is arranged above the touch panel 100. The air nozzle 5 has a bottom forming an air jet orifice 51 opposing and spaced from a surface of an active zone 110 of the touch panel 100 by a predetermined distance or gap.

The air nozzle 5 is connected to an air supply source 54 through a conduit 52 and a flow switch unit 53. The air supply source 54 supplies air of preset pressure through the conduit 52 under the control of the flow switch unit 53 to the air nozzle 5.

The touch panel 100 is set in such a way that a signal transmission line 15 connects the touch panel 100 to a testing system 6. The testing system 6 is preloaded with programs or software for signal reading and analysis. The testing system 6 receives a touch signal from the touch panel 100, analyzes and processes the touch signal to show up data associated with the touch signal on a display device 61 of the testing system 6. The testing system 6 can be for example a computer based facility that is dedicated for testing of touch panels, or alternatively, the testing system 6 can be a regular, general-purpose computer that is pre-loaded with the signal-reading and analysis programs or software and is connectable to the touch panel to be inspected.

The testing system 6 provides a movement control signal S 1 to control the operation of a movement control mechanism 62 that causes the air nozzle 5 to move along a predetermined route. The testing system 6 also provides a switch control signal S2 to control the operation of the flow switch unit 53 in order to selectively conduct/shut down the supply of air from the air supply source 54 to the air nozzle 5. The flow switch unit 53 can be for example an electromagnetic control valve or an equivalent flow control system.

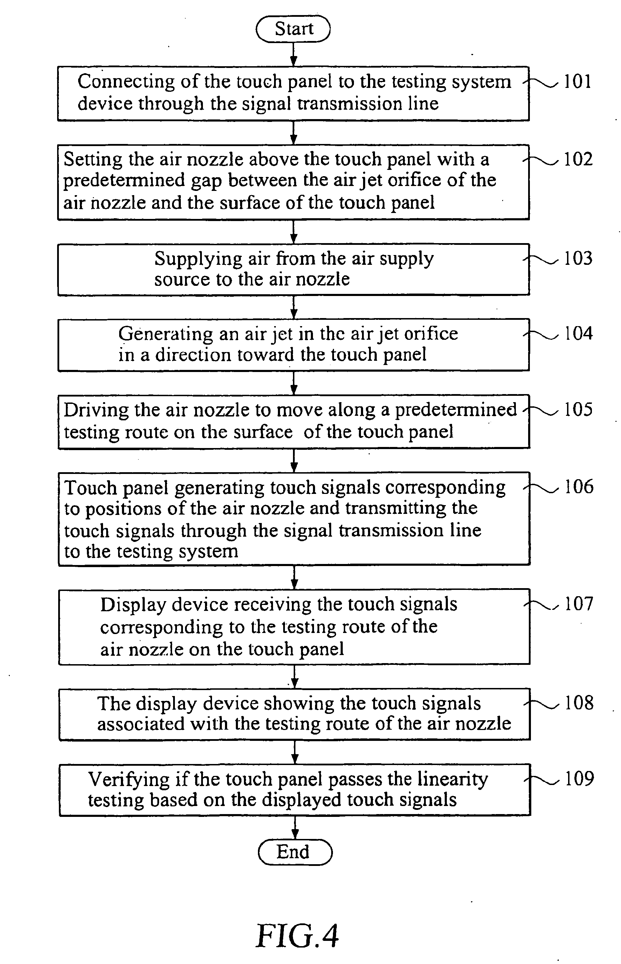

Figure 4 shows a flow chart of a non-contact testing method in accordance with the present invention for testing a touch panel. The non-contact testing method of the present invention will be described with reference to the flow chart of Figure 4 and the arrangement of testing illustrated in Figure 3.

The testing starts with connection of the touch panel 100 to the testing system 6 through the signal transmission line 15 (step 101), followed by setting the air nozzle 5 above the touch panel 100 with a predetermined gap or distance between the air jet orifice 51 at the bottom of the air nozzle 5 and the surface of the active zone 110 of the touch panel 100 (step 102).

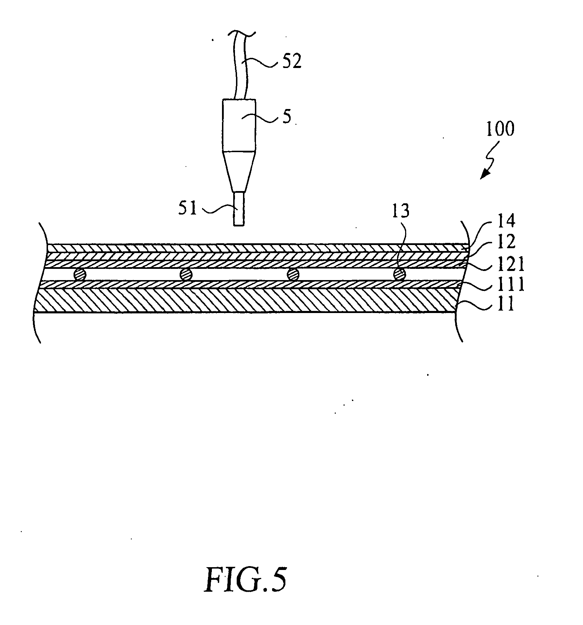

The air nozzle 5, the conduit 52, the flow switch unit 53, the air supply source 54, and the movement control mechanism 62 are properly connected. Figure 5 is a cross-sectional view illustrating the air nozzle 5 arranged above the surface of the touch panel 100 in a condition where air jet is not applied to the surface of the touch panel 100.

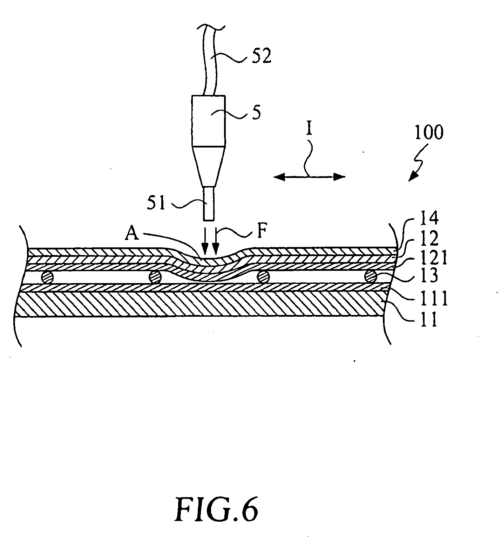

With the above pre-arrangement, testing of the touch panel 100 can then be performed. Under the control of the testing system 6, air is supplied from the air supply source 54, through the flow switch unit 53 and the conduit 52, to the air nozzle 5 (step 103) and an air jet F (please refer to Figure 6) is generated in the air jet orifice 51 at the bottom of the air nozzle 5 in a direction toward the active zone 110 of the touch panel 100 (step 104).

At the same time, under the control of the testing system 6, the movement control mechanism 62 drives the air nozzle 5 to move along a predetermined route I (as shown in Figure 6) on the surface of the touch panel 100 (step 105).

Figure 6 is a cross-sectional view illustrating the air nozzle 5 that is arranged above the surface of the touch panel 100 generating an air jet F in the air jet orifice 51 of the air nozzle 5 toward the surface of the touch panel 100. As shown, the surface of the touch panel 100 is subjected to pressurization by the air jet F generated by the air jet orifice 51 at the bottom of the air nozzle 5, forming a recess A, which causes a transparent conductive layer 111 of a glass substrate 11 and a transparent conductive layer 121 of a film 12, both constituting in part the touch panel 100, to become contact with each other. As a result, the touch panel 100 generates a series of touch signals corresponding to touch positions of the air nozzle 5 that moves along the movement route I. The series of touch signal are applied through the signal transmission line 15 to the testing system 6 (step 106).

In the testing process discussed above, the movement route I of the air nozzle 5 can be set to be a linear path along a direction of either X-axis or Y-axis of the touch panel 100. Or alternatively, the route I can be set as a transverse path or a curved path.

With the method in accordance with the present invention, the generation of the touch signals in the touch panel that is conventionally done with a pressurizing testing stylus moving along the touch panel can be simulated. Further, with the method of the present invention, data or signals representing the movement route of the air nozzle 5 on the touch panel 100 in association with the series of touch signals can be displayed on the display device 61 of the testing system 6.

After receiving the touch signals corresponding to the movement route of the air nozzle 5 on the touch panel 100 (step 107), the display device 61 of the testing system 6 shows the touch signals associated with the route of the air nozzle 5 (step 108). Consequently, an operator may determines if the touch panel 100 under testing satisfies the requirements of linearity testing, as well as other electrical characteristics, based on the displayed touch signals (step 109).

## Claims

1. A method for testing a touch panel (100), the method comprising the following steps:
arranging an air nozzle (5) having an air jet orifice (51) above a surface of the touch panel (100) with a predetermined distance set between the air jet orifice (51) and the surface of the touch panel (100);
supplying an air to the air nozzle (5) to cause the air jet orifice (51) of the air nozzle (5) to generate an air jet (F) toward the top surface of the touch panel (100);
driving the air nozzle (5) to move along a predetermined testing route on the surface of the touch panel (100);
the touch panel (100) generating a series of touch signals corresponding to the movement of the air nozzle (5) along the testing route; and
receiving the touch signals to verify the touch panel (100).

2. The method as claimed in Claim 1, **characterized in that** the air nozzle (5) is connected through a flow switch unit (53) to an air supply source (54) so that the flow switch unit (53) controls the supply of air to the air nozzle (5).

3. The method as claimed in Claim 1, **characterized in that** step (e) further comprises displaying the touch signals corresponding to the movement of the air nozzle (5) along the testing route on a display device (61).

4. A non-contact testing system for testing a touch panel (100), the system comprising:
an air nozzle (5) with an air jet orifice (51) that is arranged above and spaced from a surface of the touch panel (100) at a predetermined distance;
an air supply source (54) that is connected to the air nozzle (5) by a conduit . (52) to supply an air to the air nozzle (5);
a test device (6) that is connectable to the touch panel (100) by a signal transmission line (15);
**characterized in that** the air supply source (54) supplies air to the air nozzle (5) and the air nozzle (5) generates an air jet (F) at the air jet orifice (51) in a direction toward the surface of the touch panel (100) so that the touch panel (100) responsively generates a touch signal corresponding to the air jet (F), the touch signal being applied through the signal transmission line (15) to the test device (6).

5. The non-contact testing system as claimed in Claim 4, further comprising a flow switch unit (53) coupled between the air nozzle (5) and the air supply source (54), the test device (6) providing a switch control signal (S2) that controls the flow switch unit (53) for regulating the supply of air from the air supply source (54) to the air nozzle (5).

6. The non-contact testing system as claimed in Claim 4, further comprising a movement control mechanism (62) coupled to the air nozzle (5), the test device (6) providing a movement control signal (S1) that controls the movement control mechanism (62) for driving the air nozzle (5) to move along a predetermined testing route.

## Patentansprüche

1. Methode zur Prüfung eines Touch Panels (100), in der die Methode nachfolgende Schritte umfasst:
Platzierung einer Luftstrahldüse (5) mit einer Düsenöffnung (51) über einer Fläche des Touch Panels (100) in einem vorgegebenen Abstand zwischen der Düsenöffnung (51) und der Oberfläche des Touch Panels (100);
Beaufschlagung der Luftstrahldüse (5) mit Luft, so dass an der Düsenöffnung (51) der Luftstrahldüse (5) ein Luftstrahl (F) über der obersten Fläche des Touch Panels (100) entsteht;
Antrieb der Luftstrahldüse (5) zur Bewegung derselben auf einem vorgegebenen Prüfpfad auf der Oberfläche des Touch Panels (100);
Generierung einer Anzahl von Berührungssignalen durch das Touch Panel (100) entsprechend der Bewegung der Luftstrahldüse (5) auf dem Prüfpfad; und
Empfang der Berührungssignale zur Verifizierung des Touch Panels (100).

2. Methode gemäß Anspruch 1, **dadurch gekennzeichnet, dass** die Luftstrahldüse (5) über einen Strömungsschalter (53) an eine Luftquelle (54) angeschlossen ist, so dass der Strömungsschalter (53) die Luftversorgung zur Luftstrahldüse (5) steuert.

3. Methode gemäß Anspruch 1, **dadurch gekennzeichnet, dass** der Schritt (e) des Weiteren die Wiedergabe von der Bewegung der Luftstrahldüse (5) auf dem Prüfpfad entsprechenden Berührungssignalen auf einem Wiedergabegerät (61) einbezieht.

4. Kontaktloses Prüfsystem zur Prüfung eines Touch Panels (100), wobei das System folgende Teile umfasst:
eine Luftstrahldüse (5) mit einer Düsenöffnung (51), die über und in einem
vorgegebenen Abstand von der Oberfläche des Touch Panels (100) angeordnet ist;
eine Luftquelle (54), die zur Versorgung der Luftstrahldüse (5) mit Luft über eine Leitung (52) mit der Luftstrahldüse (5) verbunden ist;
eine Prüfvorrichtung (6) , die über eine Signalübertragungsleitung (15) mit dem Touch Panel (100) in Verbindung steht;
**dadurch gekennzeichnet, dass** die Luftquelle (54) die Luftstrahldüse (5) mit Luft versorgt und die Luftstrahldüse (5) an der Düsenöffnung (51) einen auf die Oberfläche des Touch Panels (100) gerichteten Luftstrahl (F) erzeugt, so dass das Touch Panel (100) als Reaktion hierauf ein dem Luftstrahl (F) entsprechendes Berührungssignal erzeugt, wobei die Prüfvorrichtung (6) über die Signalübertragungsleitung (15) mit dem Berührungssignal beaufschlagt wird.

5. Kontaktloses Prüfsystem gemäß Anspruch 4, das des Weiteren einen zwischen der Luftstrahldüse (5) und der Luftquelle (54) angeordneten Strömungsschalter (53) aufweist, wobei die Prüfvorrichtung (6) ein Schaltersteuersignal (S2) liefert, das den Strömungsschalter (53) zur Regelung der Luftzufuhr von der Luftquelle (54) zur Luftstrahldüse (5) steuert.

6. Kontaktloses System gemäß Anspruch 4, das des Weiteren einen mit der Luftstrahldüse (5) gekoppelten Mechanismus (62) zur Bewegungssteuerung aufweist, wobei die Prüfvorrichtung (6) ein Bewegungssteuersignal (S1) liefert, das den Mechanismus (62) zur Steuerung der Bewegung der Luftstrahldüse (5) an einem vorgegebenen Prüfpfad entlang steuert.

## Revendications

1. Procédé permettant de tester un panneau tactile (100), le procédé comportant les étapes suivantes :
arranger une buse d'air (5) ayant un orifice de jet d'air (51) au-dessus d'une surface du panneau tactile (100) selon une distance prédéterminée mise en oeuvre entre l'orifice de jet d'air (51) et la surface du panneau tactile (100) ;
fournir un air à la buse d'air (5) pour amener l'orifice de jet d'air (51) de la buse d'air (5) à générer un jet d'air (F) vers la surface supérieure du panneau tactile (100) ;
entraîner la buse d'air (5) à se déplacer le long d'une trajectoire d'essai prédéterminée sur la surface du panneau tactile (100) ;
le panneau tactile (100) générant une série de signaux tactiles correspondant au mouvement de la buse d'air (5) le long de la trajectoire d'essai ; et
recevoir les signaux tactiles pour vérifier le panneau tactile (100).

2. Procédé selon la revendication 1, **caractérisé en ce que** la buse d'air (5) est connectée par le biais d'un module interrupteur de débit (53) au niveau d'une source d'alimentation en air (54) de sorte que le module interrupteur de débit (53) commande l'alimentation de l'air jusqu'à la buse d'air (5).

3. Procédé selon la revendication 1, **caractérisé en ce que** l'étape (e) comporte par ailleurs l'affichage des signaux tactiles correspondant au mouvement de la buse d'air (5) le long de la trajectoire d'essai sur un dispositif d'affichage (61).

4. Système d'essai sans contact permettant de tester un panneau tactile (100), le système comportant :
une buse d'air (5) avec un orifice de jet d'air (51) qui est arrangée au-dessus d'une surface du panneau tactile (100) et espacée de celle-ci à une distance prédéterminée ;
une source d'alimentation en air (54) qui est connectée au niveau de la buse d'air (5) par une conduite (52) pour alimenter de l'air jusqu'à la buse d'air (5) ;
un dispositif d'essai (6) qui est en mesure d'être connecté au niveau du panneau tactile (100) par une ligne de transmission de signaux (15) ;
**caractérisé en ce que** la source d'alimentation en air (54) alimente de l'air jusqu'à la buse d'air (5) et la buse d'air (5) génère un jet d'air (F) au niveau de l'orifice de jet d'air (51) dans une direction allant vers la surface du panneau tactile (100) de sorte que le panneau tactile (100) génère en réaction un signal tactile correspondant au jet d'air (F), le signal tactile étant appliqué au travers de la ligne de transmission de signaux (15) au niveau du dispositif d'essai (6)

5. Système d'essai sans contact selon la revendication 4, comportant par ailleurs un module interrupteur de débit (53) couplé entre la buse d'air (5) et la source d'alimentation en air (54), le dispositif d'essai (6) procurant un signal de commande d'interrupteur (S2) qui commande le module interrupteur de débit (53) pour réguler l'alimentation en air depuis la source d'alimentation en air (54) jusqu'à la buse d'air (5).

6. Système d'essai sans contact selon la revendication 4, comportant par ailleurs un mécanisme de commande de mouvement (62) couplé à la buse d'air (5), le dispositif d'essai (6) procurant un signal de commande de mouvement (S1) qui commande le mécanisme de commande de mouvement (62) pour entraîner la buse d'air (5) à se déplacer le long d'une trajectoire d'essai prédéterminée.
